Europäisches Patentamt

**(19)** European Patent Office

Office européen des brevets

**(11)** Publication number : **0 280 539 B1**

**(12)** # EUROPEAN PATENT SPECIFICATION

**(45)** Date of publication of patent specification :
22.01.92 Bulletin 92/04

**(51)** Int. Cl.⁵ : **B08B 7/00,** C23G 5/00

**(21)** Application number : 88301597.6

**(22)** Date of filing : 24.02.88

**(54)** A method of removing undesired carbon deposits from the inside of a CVD reaction chamber.

**(30)** Priority : 24.02.87 JP 41749/87

**(43)** Date of publication of application :
31.08.88 Bulletin 88/35

**(45)** Publication of the grant of the patent :
22.01.92 Bulletin 92/04

**(84)** Designated Contracting States :
**DE FR GB**

**(56)** References cited :
US-A- 4 555 303
PATENT ABSTRACTS OF JAPAN, vol. 8, no.
145 (C-232)[1582], 6th July 1984; & JP-A-59 50
179 (NIPPON SHINKU GIJUTSU K.K.) 23-
03-1984

**(56)** References cited :
PATENT ABSTRACTS OF JAPAN, vol. 11, no.
75 (C-408)[2522], 6th March 1987; & JP-A-61
231 180 (OKI ELECTRIC IND CO., LTD.) 15-
10-1986
PATENT ABSTRACTS OF JAPAN, vol. 5, no
153 (E-76)[825], 26th September 1981; & JP-
A-56 87 325 (CHO LSI GIJUTSU KENKYU
KUMIAI) 15-07-81
THIN SOLID FILMS, vol. 69, no. 3, 1980, pages
359-368, Elsevier Sequoia S.A., Lausanne, CH;
M.A.BAKER: "Plasma cleaning and the re-
moval of carbon from metal surfaces"

**(73)** Proprietor : SEMICONDUCTOR ENERGY
LABORATORY CO., LTD.
398 Hase
Atsugi-shi Kanagawa-ken, 243 (JP)

**(72)** Inventor : Yamazaki, Shunpei
21-21 Kitakarasuyama 7-Chome
Setagaya-Ku Tokyo 157 (JP)

**(74)** Representative : Milhench, Howard Leslie et al
R.G.C. Jenkins & Co. 26 Caxton Street
London SW1H 0RJ (GB)

EP 0 280 539 B1

Note : Within nine months from the publication of the mention of the grant of the European patent, any
person may give notice to the European Patent Office of opposition to the European patent granted.
Notice of opposition shall be filed in a written reasoned statement. It shall not be deemed to have been
filed until the opposition fee has been paid (Art. 99(1) European patent convention).

Jouve, 18, rue Saint-Denis, 75001 PARIS

# Description

This invention relates to a method of eliminating undesired deposits from the inside of a CVD reaction chamber.

Recently, we have proposed a new method of depositing carbon films on substrates which involves the application of microwave and magnetic energy to a carbon compound gas in a vacuum chamber. The resultant chemical vapour reaction unavoidably causes undesired deposits to form on the inside of the reaction chamber.

It has been known as a technique for removing such deposits to subject the deposited carbon film to etching, and it has been known particularly to etch amorphous carbon film by means of Electron Cyclotron Resonance (ECR). In the prior art, active etchant particles derived for example from a fluorine or chlorine compound gas have been produced by ECR at such a low pressure that electrons at least can describe respective circular paths and have been drifted to the region of a substrate disposed apart from the resonating space by virtue of a divergent magnetic field.

However, in such a prior art method the apparatus is subjected to accelerated wear because of the use of fluorine or chlorine compound as an etchant gas and in particular the oil utilized in the evacuation of the reaction chamber is degraded. For this reason, it is required to be able to remove undesired deposits from the inside of the reaction chamber without making use of a fluorine or chlorine compound gas to clean the reaction chamber so that, after removal of the substrate coated with a film composed mainly of carbon or its compound(s) from the chamber, the inside wall of the reaction chamber may be cleaned without being damaged by erosion.

U.S. Patent 4,555,303 (Legge et al.) discloses a process for removing carbonaceous material from a surface in a high pressure (i.e. above 100 Torr) oxygen plasma. The plasma is generated by applying radiofrequency radiation (e.g. 13.56 MHz) to the oxygen. In this process, it is a layer of graphite which is removed from polycrystalline silicon ribbons which are localised within a reaction chamber. In contrast, the present invention concerns an etching method for removing deposits from inside the reaction chamber itself, such deposits clearly not being localised. Thus, this patent does not teach removal of such deposits.

Patent Abstracts of Japan, Vol. 8, No. 145 (C-232) [1582] describes a method of judging the end point of a cleaning process wherein a plasma is generated in an oxygen atmosphere in a vacuum vessel. In this case, a hydrocarbon polymer which has become stuck on the internal wall of the vacuum vessel is removed by the plasma.

## Summary of the Invention

It would therefore be desirable to provide a method of cleaning a CVD apparatus by removing undesirable products by etching without damaging the inside of the CVD apparatus.

According to the present invention there is provided an etching method for removing deposits from inside the reaction chamber of an apparatus for the deposition of a material onto a substrate, said method comprising:

evacuating said reaction chamber;

inputting oxygen or an oxygen compound gas into said reaction chamber; and

producing a plasma within said gas;
wherein:

said deposits are carbon deposits and said material consists mainly of carbon;

said gas serves as an etchant gas;

said gas input into said reaction chamber is at a pressure of 0.1 to 30 Torr;
said method further comprising:

establishing a magnetic field in said reaction chamber; and

inputting microwave radiation into said reaction chamber to produce said plasma, said plasma being derived from said gas.

The present invention thus proposes that etching be implemented by making use of oxygen and/or an oxygen compound gas (such as NO, $NO_2$, $N_2O$, $H_2O$ and the like) as the gas etchant which does not cause damage to the inside of the chamber. As a preferred feature of the invention, the strength of the magnetic field in the reaction chamber may be varied in order to shift the position where the microwave electric field takes its maximum value in correspondence with an ECR condition and where oxygen in the vicinity is maintained in an excited condition. By virtue of this varying of the magnetic field, a high energy plasma can be caused to move along the entire inside surface of the vacuum chamber so as to eliminate undesired carbon deposited thereon.

Other features of the invention are set forth in the appended claims and will be clearly understood from consideration of the following description given with reference to the accompanying drawings.

## BRIEF DESCRIPTION OF THE DRAWINGS

Fig.1 is a cross sectional view showing an exemplary CVD apparatus in which etching may be carried out in accordance with the present invention;

Fig.2(A) is a graphical diagram showing a computer simulation of the profiles of the equipotential surfaces in a cross section through a magnetic field developed in the apparatus of Fig.1;

Fig.2(B) is a graphical diagram showing a computer simulation of the strength of an electric field developed in the apparatus of Fig.1; and

Figs.3(A) and 3(B) are graphical diagrams showing the distribution of magnetic and electric fields respectively arising from the propagation of microwave energy into a resonating space of the apparatus of Fig.1.

## DETAILED DESCRIPTION OF THE PREFERRED EMBODIMENTS

Before describing an etching process in accordance with the present invention, an exemplary carbon deposition process will first be briefly explained. A substrate to be coated with a carbon film is disposed in the reaction chamber of a CVD apparatus and heated to 600-1000°C, e.g. 850°C, in a vacuum. Hydrogen gas is inputted to the reaction chamber so that the pressure in the chamber is gradually elevated to 0.1 to 300 Torr. Further, a carbon compound gas such as methane, ethylene or acetylene is introduced at such a flow rate that the proportion of carbon compound becomes 0.1-5% in the mixture of hydrogen and carbon compound, e.g. at methane/hydrogen = 1.5%. Then, microwave energy and a magnetic field are applied to the reactive gas. By virtue of this electromagnetic power, hydrogen plasma is produced at a high density $10^2$-$10^5$ times as high as that obtained in a prior art ECR CVD. In such a highly dense plasma phase, amorphous carbon is selectively removed so that crystalline carbon (mainly diamond) is deposited. Such a high density hydrogen plasma has been available only at a comparatively high pressure. In such high pressure conditions, Mixed Cyclotron Resonance (MCR) takes place rather than ECR. MCR is a new type of resonance which appears together with the whistler mode.

After completing the formation of carbon film, in accordance with the teachings of the present invention the microwave input and the application of magnetic field are ended and the pressure of the chamber is returned to atmospheric pressure by introducing air into the chamber followed by cooling. Then, the substrate, on which there is deposited an i-carbon (a mixture of diamond and amorphous carbon) layer or a crystalline layer composed of diamond, is removed from the chamber, and the substrate holder is returned to the chamber. The chamber is exhausted again, and oxygen ($O_2$) is introduced. By virtue of the associated action between the microwave energy and the magnetic field, active oxygen is created which eliminates, by etching, undesired deposits formed on the inside wall of the reaction chamber during the formation of the i-carbon or diamond on the substrate. The pressure of the chamber is maintained at 1.0 to 10 Torr.

As an option, when a highly dense plasma is generated by means of the associated action of microwave energy and a magnetic field, the plasma may be irradiated with high energy light such as ultraviolet light so as continuously to pump energy into the etchant gas. By this means, highly excited oxygen can be obtained throughout a region 1-50 cm distant from the highly dense plasma generating region where the microwave electric field has its maximum strength, and therefore it becomes possible to remove carbon deposition by etching broadly in the chamber.

In the etching process according to the present invention, oxygen or an oxygen compound gas is employed as the etchant gas rather than a fluorine or chlorine compound gas, and therefore the etching process causes no damage to the inside of the reaction chamber and to the substrate holder. Undesired carbon can be removed in the form of gaseous carbon dioxide. As a result, it is not necessary to make use of wet etching in order to eliminate hard carbon deposits from the inside of the chamber.

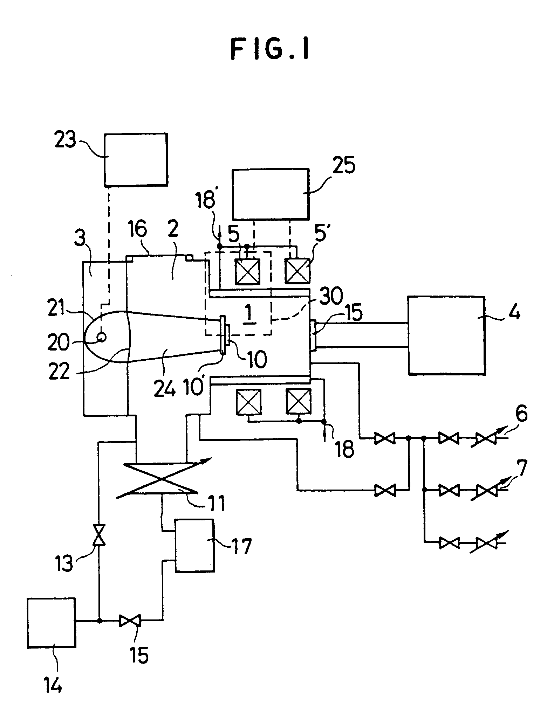

Hereinbelow, a process in accordance with the present invention is explained in conjunction with the accompanying drawings. In Fig.1, an exemplary microwave enhanced plasma CVD apparatus in accordance with the present invention is illustrated. As shown in the figure, the apparatus comprises a reaction chamber defining a plasma generating space 1 and an auxiliary space 2 which can be maintained at an appropriate negative pressure, a microwave generator 4, electro-magnets 5 and 5' in the form of Helmholtz coils surrounding the space 1, a power supply 25 for supplying the electro-magnets 5 and 5', and a water cooling system 18. For evacuating the reaction chamber there is provided an evacuating system comprising a turbo molecular pump 17 and a rotary pump 14 which are connected to the reaction chamber through pressure controlling valves 11, 13 and 15.

The plasma generating space 1 has a circular cross section and, within the plasma generating space 1, there is provided a substrate holder 10' on which a substrate 10 may be mounted, the substrate holder being made of a material such as aluminium nitride which provokes minimum disturbance of the magnetic field created by the magnets 5 and 5'. The substrate holder 10' is irradiated and heated to 600-1000°C, e.g. 800°C in a high temperature plasma gas atmosphere by means of infrared radiation 24 which is emitted from an IR heater 20, reflected from an IR reflection parabolic mirror 21 and focused on the back surface of the holder 10' through a lens 22. Reference numeral 23 designates a power supply for the IR heater 20. The substrate temperature may reach a sufficient level solely by virtue of the plasma gas generated in the reaction chamber and in this case, the heater 20 can be dispensed with. Further, depending on the condition of the plasma, the substrate temperature might become too high to enable a suitable reaction to occur, in which case cooling means for the substrate has to be provided.

In use of the above described apparatus, a substrate 10 is mounted on the substrate holder 10', and the reaction chamber is evacuated to $1 \times 10^{-6}$ Torr or to a higher vacuum condition. Then, hydrogen gas is introduced from a gas introducing system 6 at 100 SCCM. In addition to the introduction of the hydrogen gas, a productive gas comprising a gaseous carbon compound such as $C_2H_2$, $C_2H_4$, $CH_3OH$, $C_2H_5OH$ or $CH_4$ for example is inputted at 1.5 SCCM through a gas introduction system 7. Microwave energy at a power level of 500 Watts and a frequency of 2.45GHz is injected from the microwave generator 4 through a microwave introduction window 15 into the plasma generating space 1 which is subjected at the same time to a magnetic field of about 2 K Gauss generated by the magnets 5 and 5'. The reactive gas is excited into a high density plasma state in the space 1. By making the pressure of reactive gas in the reaction space 1 as high as 0.1 - 300 Torr, preferably 3 to 300 Torr, e.g. 10 Torr, the density of hydrogen radicals and the growth rate of diamond are made high.

Next, the heating of the substrate 10 and the introduction of microwave and magnetic energy are stopped, and the substrate 10 is removed from the reaction chamber. With the substrate holder 10' put back into the reaction chamber, the inside of the chamber is then heated to 500-1000°C and oxygen is inputted thereto. Keeping the pressure in the chamber at 0.1 to 10 Torr, microwave and magnetic energy is applied to the reaction space in the same way as discussed above for deposition and undesired carbon deposits will be eliminated from the inside of the chamber.

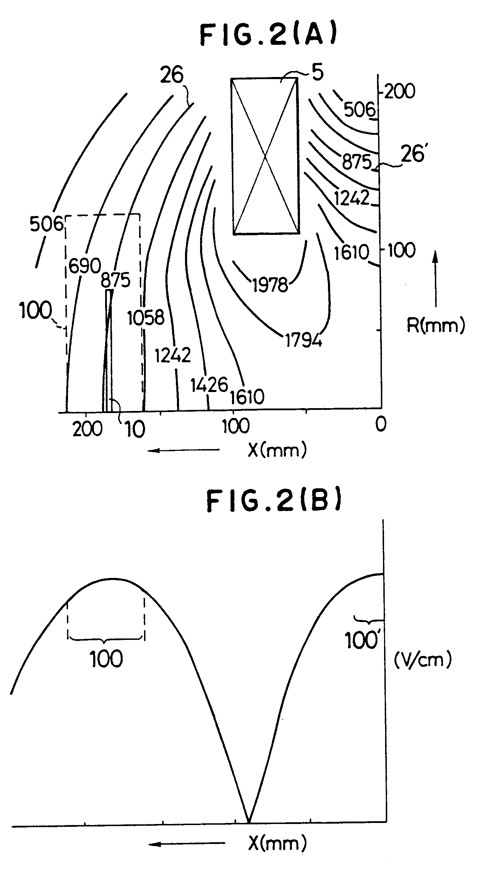

Fig.2(A) is a graphical showing of the distribution of the magnetic field in the region 30 in Fig.1. The curves in the diagram are plotted along equipotential surfaces and are given numerals indicating the strengths along the respective curves of the magnetic field induced by the magnets 5 and 5' having a power of 2000 Gauss. By adjusting the power of the magnets 5 and 5', the strength of the magnetic field can be controlled so that the magnetic field becomes largely uniform over the surface to be coated which is located in the region 100 where the magnetic field (875±185 Gauss) and the electric field interact. In the diagram, the reference 26 designates the equipotential surface of 875 Gauss at which the conditions required for ECR (Electron Cyclotron Resonance) between the magnetic field and the microwave energy are satisfied. Of course, in accordance with the present invention, ECR cannot be established due to the high pressure in the reaction chamber, but instead a Mixed Cyclotron Resonance (MCR) takes place in a broad region including the equipotential surface which satisfies ECR conditions. MCR appears together with the whistler mode. Fig.2(B) is a graphical diagram in which the X-axis corresponds to that of Fig.2(A) and which shows the strength of the electric field of the microwave energy in the plasma generating space 1. As shown, the strength of the electric field takes its maximum value in the regions 100 and 100'. However, in the region 100', it is difficult to heat the substrate 10' without disturbing the propagation of the microwave energy. Also, in this region, the strength of the magnetic field becomes disparate so that rapid etching is accomplished only at the region where the ECR condition is satisfied. In other regions, a film cannot uniformly undergo etching. It is for this reason that the region 100 is considered to be the most suitable place for etching when etching of a substrate is desired.

When the output power of the microwave generator is 500 W, the etching speed is 0.3 micron/min. However, the etching speed can be elevated by a factor of approximately three by increasing the power to 1.2KW. Also the etching speed can be increased by elevating the pressure in the reaction chamber, e.g. within the pressure range from 0.1 Torr to 30 Torr. However, in practice it becomes difficult to maintain the etchant gas in an appropriate plasma condition at higher than 30 Torr.

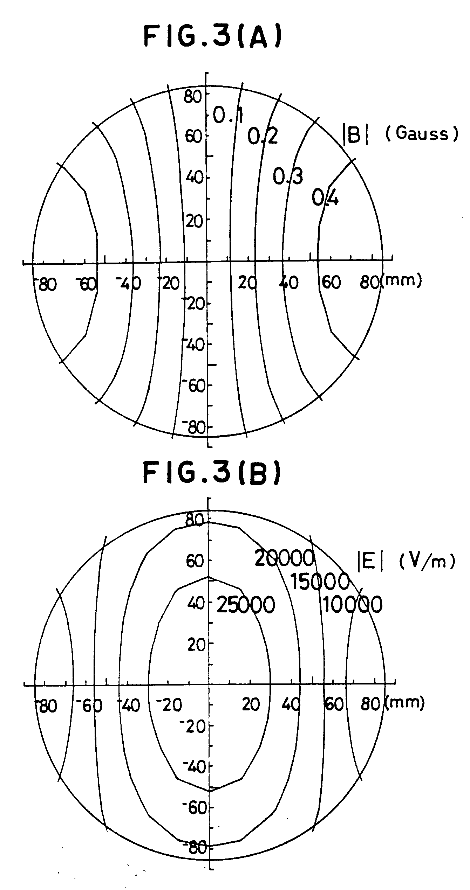

Figs.3(A) and 3(B) are graphical diagrams showing the distributions of the magnetic field and the electric field due to microwave energy emitted from the microwave generator 4 for a cross section of the plasma generating space 1. The curves in the circles of the figures are plotted along equipotential surfaces and given numerals showing the field strengths. As shown in Fig.3(B), the electric field reaches its maximum value at 25 KV/m.

As illustrated above, in accordance with the present invention, harmful deposits which occur incidentally during carbon coating on surfaces inside the reaction chamber other than the surface to be coated can be eliminated. Furthermore, electric power can be effectively supplied since the electrodes are kept clean before carbon formation. The invention is most useful when carbon formation is repeated many times since in such a case the reaction chamber can easily be cleaned by etching according to the present invention between successive carbon formations.

In the foregoing description, "carbon" to be deposited in accordance with the present invention includes graphite, diamond amorphous, or other crystalline or non-crystalline carbon, and the form of the carbon includes a film, a layer, an aggregation, a texture, or any other form.

The invention should not be regarded as being limited to the above particular embodiments and many modifications and variations may occur to those skilled in the art without departure from the scope of the invention as defined in the appended claims.

## Claims

1. An etching method for removing deposits from inside the reaction chamber of an apparatus for the deposition of a material onto a substrate, said method comprising:

evacuating said reaction chamber;

inputting oxygen or an oxygen compound gas into said reaction chamber; and

producing a plasma within said gas;

wherein:

said deposits are carbon deposits and said material consists mainly of carbon;

said gas serves as an etchant gas;

said gas input into said reaction chamber is at a pressure of 0.1 to 30 Torr;

and wherein said method further comprises:

establishing a magnetic field in said reaction chamber; and

inputting microwave radiation into said reaction chamber to produce said plasma, said plasma being derived from said gas.

2. The method of claim 1 wherein said carbon material is diamond or a diamond like carbon.

3. The method of claim 1 wherein the inside of said reaction chamber is heated to 500-1000°C.

4. The method of any preceding claim wherein said etching is carried out while the inside of said chamber is irradiated with light.

5. The method of claim 4 wherein said light is ultraviolet light.

6. The method of any preceding claim wherein the etching is carried out before another carbon deposition.

7. The method of any preceding claim wherein the strength of the magnetic field is varied.

## Patentansprüche

1. Verfahren zum Wegätzen von Ablagerungen aus dem Innern der Reaktionskammer einer Vorrichtung zum Auftragen eines Materials auf ein Substrat, umfassend:

Evakuieren der Reaktionskammer,

Einleiten von Sauerstoff oder einer gasförmigen Sauerstoffverbindung in die Reaktionskammer, und

Erzeugen eines Plasmas in dem Gas,

wobei

die Ablagerungen Kohlenstoffablagerungen sind und das Material im wesentlichen aus Kohlenstoff besteht,

das Gas als Ätzgas dient, und

das in die Reaktionskammer eingeleitete Gas bei einem Druck von 0,1 bis 30 Torr vorliegt, und wobei das Verfahren ferner umfaßt:

Ausbilden eines Magnetfeldes in der Reaktionskammer, und

Einfleiten von Mikrowellenstrahlung in die Reaktionskammer zur Erzeugung des Plasmas, wobei dieses aus dem Gas abgeleitet wird.

2. Verfahren nach Anspruch 1, wobei das Kohlenstoff-Material Diamant oder diamantartiger Kohlenstoff ist.

3. Verfahren nach Anspruch 1, wobei das Innere der Reaktionskammer auf 500 bis 1000°C erwärmt wird.

4. Verfahren nach einem der vorhergehenden Ansprüche, wobei das Ätzen durchgeführt wird, während das Innere der Kammer mit Licht bestrahlt wird

5. Verfahren nach Anspruch 4, wobei das Licht Ultraviolettlicht ist

6. Verfahren nach einem der vorhergehenden Ansprüche, wobei das Ätzen vor einer weiteren Kohlenstoffablagerung durchgeführt wird.

7. Verfahren nach einem der vorhergehenden Ansprüche, wobei die Stärke des Magnetfelds geändert wird.

## Revendications

1. Procédé de décapage destiné à éliminer des dépôts de l'intérieur de la chambre de réaction d'un appareil servant à l'application d'une matière sur un substrat, ledit procédé consistant à:

faire le vide dans ladite chambre de réaction;

introduire de l'oxygène ou un composé gazeux oxygéné dans ladite chambre de réaction; et

produire un plasma dans ledit gaz;

dans lequel:

lesdits dépôts sont des dépôts de carbone et ladite matière est constituée principalement de carbone;

ledit gaz sert de gaz de décapage;

ladite introduction de gaz dans ladite cbambre de réaction s'effectue à une pression de 0,1 à 30 torrs; et dans lequel ledit procédé comprend en outre:

l'établissement d'un champ magnétique dans ladite chambre de réaction; et

l'introduction d'un rayonnement de micro-ondes dans ladite chambre de réaction pour produire ledit plasma, ledit plasma étant obtenu à partir dudit gaz.

2. Procédé selon la revendication 1, dans lequel ladite matière est du diamant ou un carbone similaire à du diamant.

3. Procédé selon la revendication 1, dans lequel l'intérieur de ladite chambre de réaction est chauffé jusqu'à 500-1000°c.

4. Procédé selon l'une quelconque des revendications précédentes, dans lequel le décapage est effectué pendant que l'intérieur de ladite chambre est irradié de lumière.

5. Procédé selon la revendication 4, dans lequel ladite lumière est de la lumière ultraviolette.

6. Procédé selon l'une quelconque des revendications précédentes, dans lequel le décapage est effectué avant une autre opération d'application de carbone.

7. Procédé selon l'une quelconque des revendications précédentes, dans lequel on fait varier l'intensité du champ magnétique.

# FIG.1

# FIG.2(A)

# FIG.2(B)

# FIG.3(A)

# FIG.3(B)